Europäisches Patentamt

European Patent Office

Office européen des brevets

(11) Veröffentlichungsnummer: **0 216 788**
**B1**

(12) **EUROPÄISCHE PATENTSCHRIFT**

(45) Veröffentlichungstag der Patentschrift: **25.04.90**

(51) Int. Cl.⁵: **G 01 R 11/04, H 05 K 7/14**

(21) Anmeldenummer: **86900731.0**

(22) Anmeldetag: **06.02.86**

(86) Internationale Anmeldenummer:
**PCT/CH86/00015**

(87) Internationale Veröffentlichungsnummer:
**WO 86/04994 28.08.86 Gazette 86/19**

(54) **IN EIN ELEKTRIZITÄTSZÄHLERGEHÄUSE EINGEBAUTES TARIFGERÄT.**

(30) Priorität: **15.02.85 CH 716/85**

(43) Veröffentlichungstag der Anmeldung:
**08.04.87 Patentblatt 87/15**

(45) Bekanntmachung des Hinweises auf die
Patenterteilung:
**25.04.90 Patentblatt 90/17**

(84) Benannte Vertragsstaaten:
**AT BE CH DE FR GB IT LI NL SE**

(56) Entgegenhaltungen:
DE-A-2 639 230
DE-A-2 712 918
DE-A-2 946 281
US-A-4 321 531

Landis & Gyr-Mitteilungen, vol. 27, No. 2, 1980,
Zug (CH) A. Spälti: "Ein Tarifapparat zur
kontinuierlichen Bewertung der beanspruchten
elektrischen Leistung", pages 2-10

(73) Patentinhaber: **LGZ LANDIS & GYR ZUG AG
CH-6301 Zug (CH)**

(72) Erfinder: **THIEBAUD, Michel
Ringstrasse 17
CH-6331 Hagendorm (CH)**
Erfinder: **MUNTWYLER, Hans
Erlibergstrasse 11a
CH-6314 Unterägeri (CH)**
Erfinder: **MEIERHANS, Karl
Erlistrasse 6b
CH-6312 Steinhausen (CH)**

(74) Vertreter: **Müller, Hans-Jürgen, Dipl.-Ing. et al
Müller, Schupfner & Gauger Lucile-Grahn-
Strasse 38 Postfach 80 13 69
D-8000 München 80 (DE)**

**Beschreibung**

Die Erfindung bezieht sich auf ein in eim Elektrizitätszähler gehäuse eingebautes Tarifgerät der im Oberbegriff des Anspruchs 1 genannten Gattung.

Ein derartiges als 'Maximumwerk" bezeichnetes Tarifgerät ist bereits bekannt (DE—A—26 39 230). Dabei wird eine kleine gedruckte Schaltung in Dickfilmtechnik verwendet, die in einem Zusatzgehäuse untergebracht ist. Die elektromagnetische Abschirmung bereitet jedoch oft Schwierigkeiten.

Darüber hinaus it est auch bekannt (DE—A—29 46 281, DE—B—27 12 918, DE—A—34 10 003), für die Funktion von Elektrizitätszählern erforderliche Einzelaggregate in einem Decklel oder anderem Oberteil oder Zusatzgehäuse unterzubringen, der an dem Unterteil des Zählergehäuse angebracht wird. Um unerlaubte Manipulationen an solchen Aggregaten, wie einem Sonderzählwerk zu verhindern oder bei Inspektionen kenntlich zu machen, erfolgt die Befestigung solcher Oberteile vielfach durch Plombierungen.

Darüber hinaus ist es bekannt (DIN 43 857, Teil 2, und DIN 43 860, Teil 2), in normierten Zählergehäusen untergebrachte Elektrizitätszähler nachträglich mit einem Maximumzähler auszurüsten und zwar über dem bestehenden Klemmenblock in Querlage. Obwohl hierdurch eine eindeutige Trennung des eigentlichen Elektrizitätszählers und des Maximumwerks gewährleistet ist, ergeben sich Schwierigkeiten hinsichtlich des Raumbedarfs.

Der Erfindung leigt die Aufgabe zugrunde, ein Tarifgerät der eingangs genannten Gattung dahingehend zu verbessern, daß nur ein geringer Raumbedarf bei Verwendung ewniger Einzelaggregate notwendig ist. Die Abschirmung soll mit einfachen Mitteln herstellbar sein. Auch die Montage und Demontage des Tarifgeräts am Elektrizitätszähler mit der Abschirmung soll problemlos erfolgen können, ohne daß die separate Eichung und Prüfung der beiden Einzelgeräte, des Tarifgeräts einerseits und des Elektrizitätszählers andererseits zu wünschen übrig läßt.

Die Erfindung ist im Anspruch 1 gekennzeichnet und in abhämgigem Ansprüchen sind weitere Ausbildungen desselben beansprucht.

Ausführungsbeispiele der Erfindung werden im folgenden anhand der schematischen Zeichnung näher erläutert. Dabei zeigen:

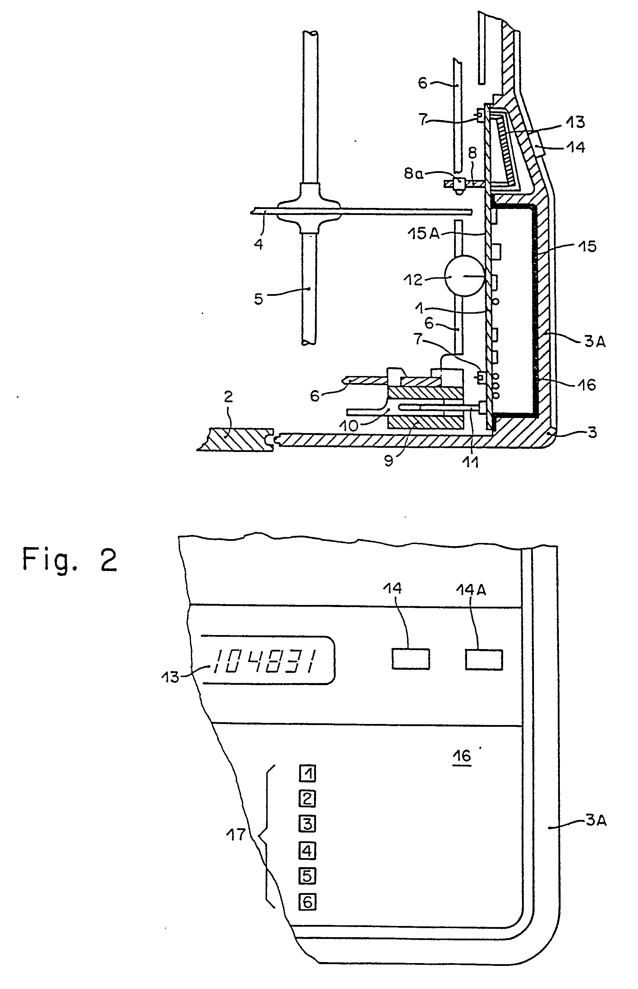

Fig. 1 einen Schnitt durch ein Tarifgerät in der unteren Sichtpartie eines Ferraris-Zählers.

Fig. 1 eine Skala;

Fig. 3 eine Ansicht eines Zählerrahmens von vorn;

Fig. 4 eine Seitenansicht eines Zählerrahmens

Fig. 5 und 8 einen Schnitt durch die unterste Partie eines Tarifgeräts in einem Ferrariszähler und

Fig. 6 und 7 einen Schnitt durch ein Tarifgerät in der unteren Sichtpartie eines Ferrariszählers.

Im Schnitt durch die untere Sichtpartie eines Ferrariszählers mit einem eingebauten Tarifgerät 1 nach der Fig. 1 ist eine Leiterplatte dieses Tarifgeräts 1 dargestellt. Sie ist in einem in ein Unterteil 2 eines Zählergehäuses eingreifenden speziell geformten, transparenten Oberteil 3 angeordnet und zwar auf dessen Innenseite in unmittelbarer Nähe von einer in der unteren Sichtpartie des Oberteils 3 vorgesehenen, nach aussen vorspringenden Erhöhung 3A des Oberteils 3. Im Inneren des Zählergehäuses ist eine Zählerrotorscheibe 4 auf einer Achse 5 dargestellt, welche sich in nichtgezeichneten Lagern drehen kann. Diese werden von einem am Unterteil 2 befestigten Zählerrahmen 6 getragen, von dem nur eine Einzelplatte in der Fig. 1. sichtbar ist. Triebsysteme des Ferrariszählers sind der besseren Uebersichtlichkeit halber in der Zeichnung weggelassen. Auch die Ableseeinrichtung ist nicht dargestellt.

Das Tarifgerät 1 mit mittels Schrauben 7 am Oberteil 3 befestigt. Das Tarifgerät 1 trägt eine Leiterplatte 8 mit einem optischen oder induktiven Abtastelement 8a für die Zählerrotorscheibe 4. Am untersten Ende des Zählerrahmens 6 ist ein Buchsenhalterstück 9 befestigt. In deren Buchsen 10 können Stecker 11 des am Oberteil 3 des Gehäuses befestigten Tarifgeräts 1 eingesteckt werden, wenn das Oberteil 3 mit dem zugehörigen Unterteil 2 verbunden wird. Auf analoge Weise kann das Tarifgerät 1 jedoch auch mit einem vollelektronischen Elektrizitätszähler verbunden werden.

Das Tarifgerät 1 ist vollelektronisch und wird mittels der Stecker 11 mit Netzspannung und den für seinen Betrieb notwendigen Daten vom Elektrizitätszähler versorgt. Anderseits werden auch die Steuerlietungen für die Tarifumschaltung, zeitliche Begrenzung der Messung, Kumulierbefehl usw. über nichtgezeichnete Klemmen für die Tarifumschaltung im Zählerklemmenstück und für die Stecker 11, auf das Tarifgerät 1 geführt. Das Tarifgerät 1 enthält ein Gleichspannungsversorgungsteil mit einem Kondensator 12, der eine gesiebte Gleichspannung für den Betrieb eines Mikro-Computers in C-MOS-Technologie mit einem quarzgesteuerten Oszillator, einer Datenein- und Ausgabe-schaltung, einem Rechenwerk und damit verbundenem nichtflüchtigem Speicher, nebst dem Befehlsspeicher für dessen Betrieb sowie für eine Flüssigkristallanzeige 13 liefert. Eingespeicherte Daten können mittels Tasten 14 in der Flüssigkristallanzeige 13 sichtbar gemacht werden. Das Tarifgerät 1 ist nach aussen mittels einer in der Konturn der nach aussen vorspringenden Erhöhung 3A angepassten Abschirmung 15 abgeschirmt. Das Tarifgerät 1 besteht aus einer SMD-(Surface Mount Device)-Schaltung, bei der ein mit Masse verbundener Teil der Abschir mung 15 rings um die Schaltung verläuft, die zudem durch den aus Kupfer bestechenden Belag 15A auf der Rückseite der SMD-Schaltung auch nach innen gegen den Zählerteil abgeschirmt ist, dich, als Abschirmung wirkt. Dies ermoglicht eine konsequente Trennung von Mechanik und Elektronik bzw. von Messwerk und Tarifgerät bei der vollelektronischen Ausführung indem das Oberteil 3 als tragendes Element ausgestaltet ist, das eine Trennung der elektronischen Teile des Tarifgeräts 1 im Oberteil 3 und der Starkstromelemente des Zählers im Unterteil 2 ermöglicht. Ferner können sowohl der Zähler wie das Tarifgerät 1 getrennt gesichtet, geprüft und getestet werden.

Zwischen der Abschirmung 15 und Erhöhung 3A ist ein Zifferblatt 16 mit Anweisungen zum Betrieb des Tarifgerätes 1 mittels der Tasten 14 vorgesehen. Diese können auch direkt auf der Abschirmung 15 aufgedruckt sein, so dass, sie von aussen sichtbar sind.

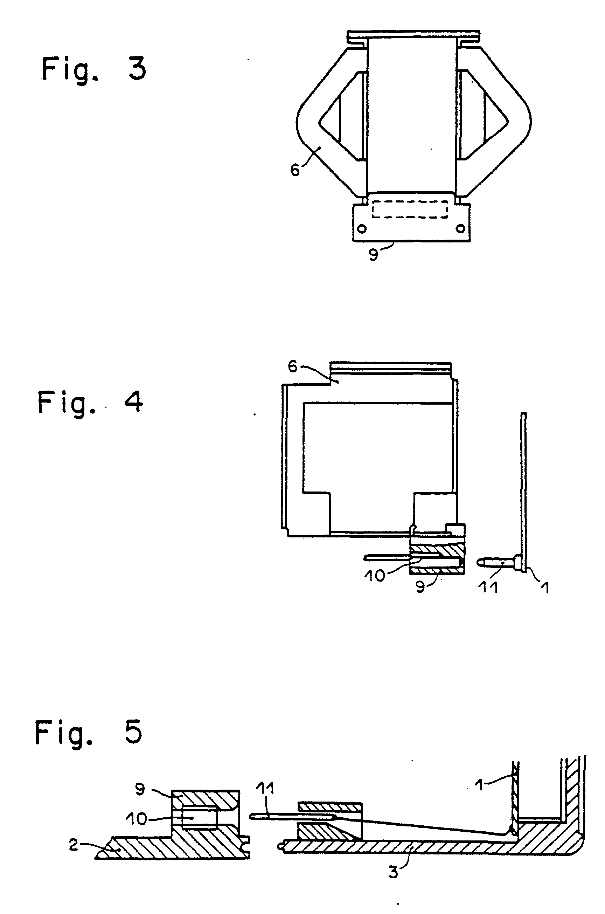

In der Fig. 2 sind die mit der Fig. 1 gemeinsamen Teile mit gleichen Kennziffern bezeichnet. Auf der nach aussen vorspringenden Erhöhung 3A des Oberteils 3 der Fig. 1 sind die Flüssigkristallanzeige 13 und zwei Tasten 14 und 14A zu erkennen. Die Taste 14 ist für Anzeigebefehle bestimmt, während die plombierbare Taste 14A sowohl für die Maximumrückstellung von Hand, wie für die Programmierung des Tarifgerätes 1 benutzt werden kann. Auf der Skala des Zifferblatts 16 sind die Anweisungen 17 samt der für jede einzelne Anweisung 17 gültigen Bezugszahl aufgedruckt. Auf diese Weise kann der Benützer eindeutig feststellen, was er bei einer Befehlseingabe für die Anzeige, bei einer Rückstellung oder Programmierung unternehmen muss. Die Fig. 3 zeigt eine Ansicht des Zählerrahmens 6 der Fig. 1 von vorn. Am Zählerrahmen 6 ist das Buchsenhalterstück 9 aufgesteckt. Auf diese Weise kann es leicht vom Zählerrahmen 6 abgehoben respektive nachbestückt werden.

In der Fig. 4 ist der Zählerrahmen 6 in Seitenansicht zusammen mit der aufgesteckten Buchsenhalterstück 9 mit den Buchsen 10 sowie als Gegenstück dazu das mittels ihrer Stecker 11 in diese einsteckbare Tarifgerät 1 dargestellt.

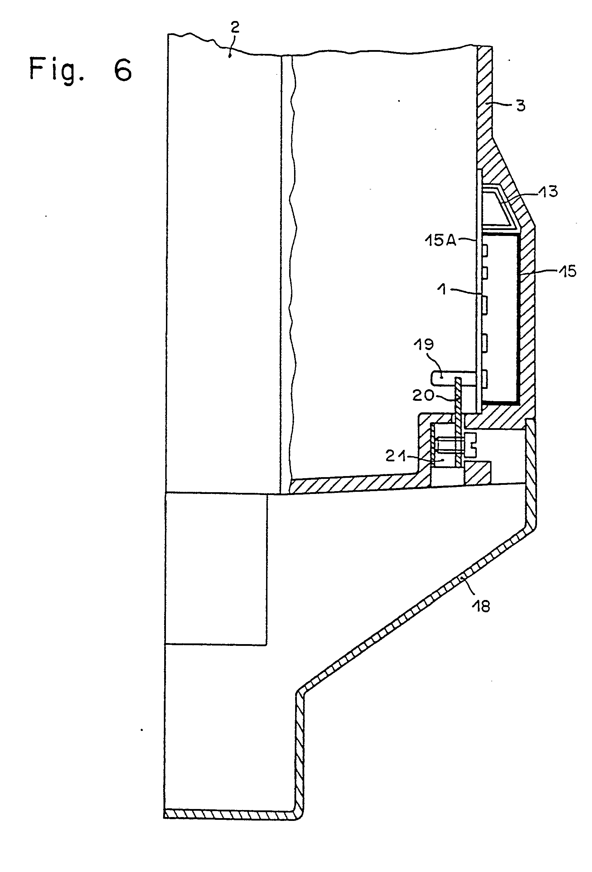

Die Fig. 5 zeigt eine Variante für die Kontaktgabe zwischen den mit dem Tarifgerät 1 verbundenen, im Oberteil 3 integrierten Steckern 11 und in einer mit dem Unterteil 2 des Zählergehäuses integrierten Buchsenplatte 9 angeordneten Buchsen 10.

Das in einen Ferrariszähler eingebaute Tarifgerät 1 der Fig. 1 kann mittels der Tasten 14 und 14A der Fig. 1 und 2 auf einfache Art bedient werden. Die Taste 14 kann gemäss den Anweisungen 17 auf dem Zifferblatt 16 der Fig. 2 für die Sichtbarmachung der anhand der Anweisung 17 auf dem Zifferblatt 16 ausgewählten Werte mittels der Flüssigkristallanzeige 13 benutzt werden. Dazu ist diese Taste 14 so oft zu drücken, wie dies der Bezugszahl für die betreffende Anweisung 17 entspricht. Die abzufragenden Angaben können den momentanen Tarif, dem momentanen Energieverbrauch, das momentane Maximum, die Anzahl der Kumulierung und die zugehörigen Monate, die seit der letzten Kumulierung oder Rücksetzung verflossene Zeit, oder weitere Vorwerte umfassen. Die Flüssigkristallanzeige 13 zeigt einen Teil der aktuellen Messwerte und Betriebszustände dauernd an, während übrige Messwerte nur nach Drücken der Taste 14 gemäss der Anweisung 16 angezeigt werden. Die plombierbare Taste 14A ist für die Rücksetzung bestimmt. Sie kann dabei zusätzlich für die Programmierung des Mikro-Computers im Tarifgerät 1 und für die Eingabe der notwendigen Daten beim erstmaligen Anschluss an den zugehörigen Ferrariszähler gebraucht werden. Dabei kann diese plombeirbare Taste 14A mit der Taste 14 logisch verknüpft sein, indem die Taste 14A als Programmschalter und die Taste 14 als Auswahlschalter wirkt. Das Tarifgerät 1 besitzt damit eine hohe Sicherheit gegen Falschprogrammeirung und eine erweiterte Anwendungsmöglichkeit.

Die Fig. 6 zeigt ebenfalls einen Schnitt durch ein in der unteren Sichtpartie eines Ferrariszählers angeordnetes Tarifgerät 1. Mit der Fig. 1 übereinstimmende Teile sind mit gleichen Bezugsziffern bezeichnet.

Dagegens sind das Buchsenhalterstück 9 und die damit zusammenwirkenden Stecker 11 der Fig. 1 in der Fig. 6 weggelassen. Die Ausführungsform nach der Fig. 6 unterscheidet sich zudem dadurch von derjenigen der Fig. 1, dass mit dem Tarifgerät 1 und mit nichtgezeichneten Leitungen des Ferrariszählers oder eines Rundsteuerempfängers verbundene Kontaktschwerter 19 vorhanden sind, welche in Kontakte 20 von in unmittelbarer Nähe des Tarifgeräts 1 angeordneten Klemmen 21 für Tarifumschaltungen einsteckbar sind. Somit erhält man unabhängig von der Zählerklemme eine zusätzliche Anzahl Klemmen 21 für Tarifumschaltungen in Zähler.

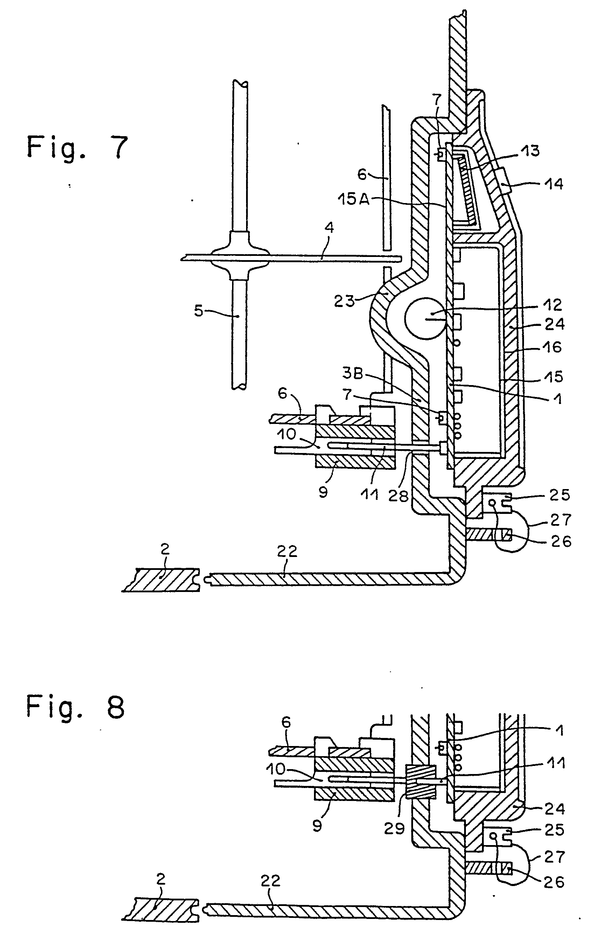

Zum Unterschied zur Ausführungsform nach der Fig. 1 ist der Fig. 7 bei einem in der unteren Sichtpartie eines Ferrariszählers angeordneten Tarifgerät 1 eine nach innen zum Zählwerk mit der Zählerrotorscheibe 4 gerichtete Einbuchtung 3B in einem speziell getormten Oberteil 22 mit einer für die Aufnahme des Kondensators 12 bestimmten Erweiterung 23 geformt. Die Einbuchtung 3B ist mit einem Deckel 24 abgeschlossen, auf dessen Innenseite das Tarifgerät 1 mittels der Schrauben 7 und die Flüssigkristallanzeige 13 befestigt sind. Der Deckel 24 wird mit Schruaben 25 dichtend auf dem Oberteil 22 befestigt, wobei die Schrauben 25 z.B. mittels eines durch eine Oese 26 im Oberteil 22 gezogenen Drahtes 27, der plombierbar ist, gesichert weden können.

Am Tarifgerät 1 sind die Stecker 11 angebracht, welche durch eine Bohrung 28 im Oberteil 22 in die Buchsen 10 der am Zählerrahmen 6 ansteckbaren Buchsenleiste 9 beim Befestigen des Deckels 24 samt Tarifgerät 1 einsteckbar sind. Dadurch kann beispeilsweise das Tarifgerät 1 samt zugehörigem Deckel 24 ausgetauscht werden, ohne dass der Ferrariszähler geöffnet und daher neu beglaubigt werden muss. Somit ist kein Zählerzusatzgehäuse nach DIN Nr 43 860 für die Plazierung des Tarifgeräts 1 nötig.

Der Schnitt durch die unterste Partie eines Tarifgeräts 1 in einem Ferrariszähler nach der Fig. 8 unterscheidet sich von der Ausführungsform nach der Fig. 7 dadurch, dass auch beim abgenommenem Deckel 24 inkl. Tarifgerät 1 ein Zwischenstecker 29 die Einbuchtung 3B im Oberteil 22 vollständig dichtend abschliesst.

Die beschriebenen Ausführungsformen eignen sich vorzüglich für die Ergänzung von bereits in Betrieb stehenden Elektrizitätszählern. Es muss nur das Buchsenhalterstück 9 mit den notwenigen Anschlüssen an das Messwerk versehen werden, wobei das Buchsenhalterstück 9 wie beschrieben auf den Zählerrahmen 6 aufgesteckt wird. Auch der Austausch des Traifgeräts 1 für Service, Revisionen oder Umbauten wird vereinfacht, was zu einem Zeitgewinn und geringeren Kosten fürht.

**Patentansprüche**

1. In ein Elektrizitätszählergehäuse eingebautes Tarifgerät (1), dessen Leiterplatte, mittels einer Abschirmung (15; 15a) gegen Störfelder abgeschirmt, in einem Oberteil (3) des Elektrizitätszählergehäuses angeordnet ist, das am Unterteil (2) befestigbar ist, dadurch gekennzeichnet, daß die Leiterplatte an der Innenseite entweder einer nach außen vorspringenden Erhöhung (3A) des Oberteils (3) oder eines Deckels (24) angeordnet ist, der eine nach innen gerichtete Einbhuchtung (3B) des Oberteils (22) abschließt, und daß die Abschimung einerseits aus einer an die Konturen der nach außen vorspringenden Erhöhung (3A) bzw. des Deckels (24) angepaßten und die Schaltung der Leiterplatte rings umgebenden Abschirmung (15) und andererseits aus einer an der der Schaltung abgewandten Rückseite der Leiterplatte als Kupferbelag (15A) aufgetragenen Abschirmung gebildet ist.

2. Tarifgerät nach Anspruch 1, dadurch gekennzeichnet, daß die Abschirmung (15) mit Masse verbunden ist.

3. Tarifgerät nach Anspruch 1 oder 2, dadurch gekennzeichnet, daß die Schaltung des Tarifgerätes (1) samt Netzgerät in SMD-Technologie ausgeführt ist.

4. Tarifgerät nach einem der vorhergehenden Ansprüche, dadurch gekennzeichnet, daß die Buchsenhalterstück (9) an einem Zählerrahmen (6) befestigt und das Tarifgerät (1) mit in Buchsen (10) dieses Buchsenhalterstücks (9) passenden Steckern (11) versehen sind.

5. Tarifgerät nach einem Ansprüche 1 bis 3, dadurch gekennzeichnet, daß ein Buchsenhalterstück (9) für am Tarifgerät angebrachte Stecker (11) im Innern des Unterteils (2) intergriert ist.

6. Tarifgerät nach einem der Ansprüche 1 bis 3, dadurch gekennzeichnet, daß das Tarifgerät (1) mit Kontaktschwertern (19) und das Oberteil (3) mit Anschlußklemmen (21) an der Erhöhung (3A) versehen ist.

7. Tarifgehäuse nach Anspruch 4, dadurch gekennzeichnet, daß die Stecker (11) eine Bohrung (28) im Oberteil (22) durchdringen.

8. Tarifgerät nach Anspruch 1, dadurch gekennzeichnet, daß ein Zwischenstecker (29) die Einbuchtung (3B) im Oberteil (22) vollständig dichtend abschließt.

9. Tarifgerät nach einem der vorhergehenden Ansprüche, gekennzeichnet durch eine Taste (14) für Anzeigebefehle und eine plombierbare Taste (14A) für die Maximumrückstellung und Programmierung des Tarifgeräts (1).

10. Tarifgerät nach einem der vorhergehenden Ansprüche, dadurch gekennzeichnet, daß eine am Tarifgerät (1) befestigte zusätzliche Leiterplatte (8) ein optisches oder induktives Abtastelement (8a) zum Abtasten einer Zählerrotorscheibe (4) trägt.

**Revendications**

1. Appareil tarifaire incorporé dans un boîtier de compteur électrique (1), sa plaque conductrice étant disposée, en étant protégée contre es champs parasitaires au moyen d'un blindage (15; 15a), dans une partie supérieure (3) du boîtier de compteur électrique, qui peut être fixé à la partie inférieure, caractérisé en ce que la plaque conductrice est disposée sur le côté intérieur soit d'un bossage (3A) de la partie supérieure (3) en saillie vers l'extérieur soit d'un couvercle (24), qui ferme un évidement (3B), orienté vers l'ntérieur, de la partie supérieure (22), et en ce que le blindage est constitué, d'une part, d'un blindage (15) adapté au contour du bossage (3A) en saillie vers l'extérieur ou du couvercle (24) et entourant annualairement le circuit de la plaque conductrice et, d'autre part, d'un blindage appliqué comme revêtement de cuivre (15A) sur le côté de la palque conductrice opposé au circuit.

2. Appareil tarifaire selon la revendication 1, caractérisé en ce que le blindage (15) est relié à la masse.

3. Appareil tarifaire selon la revendication 1 ou 2, caractérisé en ce que le circit de l'appareil tarifaire (1) est réalisé en même temps que le poste-secteur en technologie de particules montées en surface (our SMD).

4. Appareil tarifaire selon l'une des revendications précédentes caractérisé en ce qu'une pièce (9) de support de douille est fixée sur un cadre (6) de compteur et en ce quel l'appareil tarifaire (1) comporte des fiches (11) adaptées dans les douilles (10) de cette pièce (9) de support de douille.

5. Appareil tarifaire selon l'une des revendications 1 à 9, caractérisé en ce qu'une pièce (9) de support de douille destinée à des fiches (11) amenées sur l'appareil tarifare est intégrée à l'intérieur de la pièce inférieure (2).

6. Appareil tarifaire selon l'une des revendications 1 à 3, caractérisé en ce que l'appareil tarifaire comporte des lames de contact (19) et que la pièce supérieure (3) comporte sur le bossage (3A) des pinces de raccord (21).

7. Appareil tarifaire selon la revendication (4), caractérisé en ce que les fiches (11) traversent un alésage (28) de la pièce supérieure (22).

8. Appareil tarifaire selon la revendication 7, caractérisé en ce qu'une fiche intermédiaire (29) ferme complètement de façon étanche l'évidement (3B) de la partie supérieure (22).

9. Appareil tarifaire selon l'une des revendications précédentes, caractérisé par une touche (14) destinée à des instructions d'affichage et une touche plombée (14A) pour le rappel maximal et la programmation de l'appareil tarifaire (1).

10. Appareil tarifaire selon l'une des revendications précédentes caractérisé en ce qu'une plaque conductrice additionnelle (8) fixée sur l'appareil tarifaire (1) porte un appareil de détection optique ou inductif (8a) pour la détection d'un disque tournant (4) de compteur.

**Claims**

1. A tariff device (1) which is incorporated into an electricity meter housing and the printed circuit board of which, being screened from interference fields by way of a screening means (15; 15a), is disposed in an upper portion (3) of the electricity meter housing, which can be secured to the lower portion (2), characterised in that the printed circuit board is arranged at the inside either of an outwardly projecting raised portion (3A) of the upper portion (3) or of a cover (24) which closes off an inwardly directed bay portion (3B) of the upper portion (22), and that the screening means is formed on the one hand from a screen which is adapted to the contours of the outwardly projecting raised portion (3A) or the cover (24) and which extends around the circuit of the printed board, and on the other hand a screening means which is applied in the form of a copper coating (15A) to the back of the printed circuit board, which is remote from the circuit.

2. A tariff device according to claim 1 characterised in that the screeining means (15) is connected to earth.

3. A tarrif device according to claim 1 or claim 2 characterised in that the circuit of the tariff device (1) together with the mains unit is of SMD-type.

4. A tariff device according to one of the preceeding claims characterised in that a socket holder portion (9) is secured to a meter frame (6) and the tariff device (1) are provided with plug members (11) which fit into sockets (10) of the socket holder portion (9).

5. A tariff device according to one of claims 1 to 3 characterised in that a socket holder portion (9) for plug members (11) disposed on the tariff device is integrated in the interior of the lower portion (2).

6. A tariff device according to one of claims 1 to 3 characterised in that the tariff device (1) is provided with contact tongues (19) and the upper portion (3) is provided with connecting terminals (21) on the raised portion (3A).

7. A tariff device according to claim 4 characterised in that the plug members (11) pass through a bore (28) in the upper portion (22).

8. A tariff device according to claim 7 characterised in that an intermediate plug member (29) completely sealingly closes off the bay portion (3B) in the upper portion.

9. A tariff device according to one of the preceding claims characterised by a button (14) for display commands and a lead-sealable button (14A) for maximum resetting and programming of the tariff device (1).

10. A tariff device according to one of the preceding claims characterised in that an additional printed circuit board (8) secured to the tariff device (1) carries an optical or inductive sensing element (8a) for sensing a meter rotor disc (4).

Fig. 2

Fig. 3

Fig. 4

Fig. 5

Fig. 6

Fig. 7

Fig. 8